# EUROPÄISCHE PATENTSCHRIFT

(11) **EP 1 957 429 B1**
(45) Veröffentlichungstag und Bekanntmachung des Hinweises auf die Patenterteilung: **05.08.2009**
(21) Anmeldenummer: 05804563.4
(22) Anmeldetag: 17.11.2005
(51) Int. Cl.: C04B 35/56, C04B 41/50, C23C 30/00, C23C 16/22

(54) **BESCHICHTETER HARTMETALLKÖRPER**
COATED HARD METAL MEMBER
CORPS EN METAL DUR ENDUIT

(43) Veröffentlichungstag der Anmeldung: 20.08.2008
(73) Patentinhaber: BOEHLERIT GmbH & Co.KG., 8605 Kapfenberg (AT)
(72) Erfinder: GARCIA, Jose, Luis, A-1180 Wien (AT); PITONAK, Reinhard, A-8600 Bruck/Mur (AT); UDIER, Klaus, A-8043 Graz (AT)
(74) Vertreter: Wirnsberger, Gernot
(86) Internationale Anmeldenummer: PCT/AT2005/000466
(87) Internationale Veröffentlichungsnummer: WO 2007/056779

(56) Entgegenhaltungen:
- DE-A1- 2 717 842
- US-A- 4 276 096
- LENGAUER W ET AL: "Functionally graded hardmetals" JOURNAL OF ALLOYS AND COMPOUNDS, ELSEVIER SEQUOIA, LAUSANNE, CH, Bd. 338, Nr. 1-2, 16. Mai 2002 (2002-05-16), Seiten 194-212, XP004349178 ISSN: 0925-8388
- PATENT ABSTRACTS OF JAPAN Bd. 013, Nr. 461 (C-645), 18. Oktober 1989 (1989-10-18) & JP 01 179778 A (MITSUBISHI METAL CORP), 17. Juli 1989 (1989-07-17)

## Beschreibung

Die Erfindung bezieht sich auf einen beschichteten Hartmetallkörper mit erhöhter Verschleißfestigkeit, gebildet durch Sintern von Karbiden und gegebenenfalls Karbonitriden sowie Bindemetall mit einer auf den Sinterkörper aufgebrachten CVD-Beschichtung.

Weiters umfasst die Erfindung ein Verfahren zur Herstellung eines beschichteten Hartmetallkörpers.

Hartmetallkörper sind Verbundwerkstoffe und bestehen im Wesentlichen aus einer Art oder insbesondere aus mehreren Arten an Hartstoffpulvern, welche mittels eines Bindemetalls gefügt sind. Als Hartstoff werden Karbide, Nitride oder Karbonitride von Elementen der Gruppen 4,5 und 6 des Periodensystems verwendet, wobei als Bindemetall Kobalt, Nickel und/oder Eisen und Legierungen aus diesen Metallen mit Konzentrationen von 2 bis 30 Gew.-% im Körper zum Einsatz kommen Allenfalls ist der Hauptbestandteil von Hartmetall Wolframkarbid.

Hartmetallkörper verfügen im Vergleich mit vergüteten Stählen und metallischen Legierungen über eine wesentlich höhere Härte und werden vielfach als Schneidelemente wie Schneidplatten eingesetzt. Um die Schneidhaltigkeit der Schneidelemente weiter zu steigern und den Verschleiß zu vermindern, erfolgt durchwegs eine Hartstoffbeschichtung der Oberfläche des Hartmetallkörpers.

Beschichtungen auf Hartmetallkörpern sollen hochhart sein und eine hohe Haftfestigkeit am Substrat haben, um bei mechanischen und thermischen Belastungen, zum Beispiel beim Einsatz als Werkzeug zur Spanabnahme, lange Standzeiten bzw. hohe Schneidleistungen zu ermöglichen.

Eine hohe Härte der Beschichtung und der Hartmetallkörper kann jedoch die Rissinitiation, insbesondere bei stoßweiser Belastung fördern und Ausbrüche oder auch Trennbrüche bewirken.

Zur Lösung des Problems Rissinitiation und Rissfortschritt in beschichteten Hartmetallteilen wurde vorgeschlagen und ist Stand der Technik, beim Sintern und/oder durch eine Wärmebehandlung im Vakuum in der oberflächennahen Zone einen Anstieg des Bindemetall-s zu erwirken und derart eine höhere Werkstoffzähigkeit zwar mit verminderter Materialhärte in diesem Bereich einzustellen.

Eine Beschichtung mit erhöhter Dicke wirkt dabei als hochhartes, verschleißfestes Mittel und die darunterliegende, weichere und zähere Zone als Mittel zur Behinderung des Rissfortschrittes, gefolgt von dem wieder härteren und spröderen Hartmetallkörper.

Es wurde auch vorgeschlagen (DE-OS-27 17 842), zur Erhöhung der Verschleißfestigkeit der Oberfläche des Hartmetallkörpers diese aufzusticken, sodass ein nach innen abnehmender Stickstoffgehalt einer Oberflächenschicht vorliegt. Der Hartmetallgegenstand trägt dabei also keine Beschichtung, sondern die
Verschleißfestigkeit und Härte des Materials sind nach außen hin steigend ausgebildet.

Als großer Nachteil dieser mit Stickstoff angereicherten Oberflächenschicht des Hartmetallkörpers ist zu sehen, dass auf diese keine Beschichtung, welche eine hohe Haftfestigkeit auf dem Substrat aufweist, aufgebracht werden kann.

Hier will die Erfindung die Nachteile im Stand der Technik beseitigen und zielt darauf ab, einen beschichteten Hartmetallkörper der eingangs genannten Art zu schaffen, der keinen den Rissfortschritt hindernden zähen Oberflächenbereich mit einem Härteabfall aufweist, sondern eine gleichbleibende, insbesondere zu einer Beschichtung hin steigende Härte des Außenbereiches besitzt. Es ist auch Ziel der Erfindung, die Oberfläche des Hartmetallkörpers derart zu konditionieren, dass eine hochharte Beschichtung einen hohen Widerstand einer Ablösung derselben entgegensetzt. Das erfindungsgemäße Ziel umfasst auch eine Erhöhung der Verschleißfestigkeit des beschichteten Hartmetallgegenstandes bei verminderter Rissinitiation, insbesondere eine Verringerung des Kolkverschleißes bei

Weiters liegt der Erfindung die Aufgabe zugrunde, ein Verfahren zur Herstellung eines beschichteten Hartmetallkörpers, der obige Zielsetzungen aufweist, anzugeben.

Diese Ziele werden bei einem gattungsgemäßen Hartmetallkörper erreicht, bei welchem der Sinterkörper mehr als 5 Gew.-% Karbid(e) oder Karbonitrid(e) mindestens eines der Elemente Ti und/oder Nb und/oder Ta enthält, oberflächlich einen Konditionierbereich mit einem Kohlenstoffgehalt und einem nach außen hin steigenden Stickstoffgehalt aufweist und eine feinkörnige bzw. mikrokristalline Auflageschicht aus Nitrid und/oder Karbid und/oder Karbonitrid besitzt, die nach dem CVD-Verfahren bei einer Temperatur von über 900°C aufgebracht ist.

Die mit der Erfindung erreichten Vorteile sind im Wesentlichen darin zu sehen, dass durch die Zusammensetzung des Sinterkörpers eine Voraussetzung für eine Herstellung eines Konditionierbereiches an dessen Oberfläche geschaffen ist. Dieser Konditionierbereich weist vom Hartmetall-Innenbereich nach außen hin eine gleichbleibende oder stetig steigende Härte sowie einen Kohlenstoffgehalt und eine vergrößerte Stickstoffkonzentration auf, die eine Grundlage für eine hohe Haftkraft bzw. Anbindung einer Beschichtung sind. Für eine Beschichtung ist es wichtig, dass diese mittels des Hochtemperatur-CVD-Verfahrens aufgebracht ist, weil aufgrund der bei diesen Temperaturen gegebenen Reaktionskinetik besonders gute Haftungskriterien erreichbar sind. Der Kohlenstoff des Konditionierbereiches wird beim Aufbringen der Beschichtung in diese eingebaut, was zu einer besonders innigen Verbindung zwischen Bereich und Beschichtung führt. Mit anderen Worten:
Der Kohlenstoff wird von der Substratoberfläche bei einer Temperatur von 900°C und darüber praktisch in die sich bildende Beschichtung eingesaugt und vermittelt mit Stickstoff durch Diffusion einen kontinuierlichen Übergang mit überragender
Haftung der Beschichtung. Spröde Phasen oder C-Poren im Grenzbereich sind dadurch vollständig vermieden.

Es ist von Vorteil, wenn der Sinterkörper mehr als 7,5 Gew.-%, vorzugsweise mehr als 8,5 Gew.%, insbesondere mehr als 10 Gew.-% Karbide oder Karbonitride der Elemente Ti und/oder Nb und/oder Ta enthält. Niedrige Gehalte an sogenannten Mischkarbiden verschlechtern die Ausbildung des Konditionierbereiches, sodass deren Untergrenze 7,5 Gew.-% beträgt. In einer Konzentrationsspanne von 10 bis 40 Gew.-% Mischkarbide sind die besten Ausbildungsformen des Konditionlerbereiches gegeben.

Weil nun die Materialhärte des beschichteten Hartmetallgegenstandes zumeist zur Oberfläche hin steigt, kann der Sinterkörper an sich erhöhte Bindemetallgehalte und somit verbesserte Zähigkeitseigenschaften haben. Zur Vermeidung von Sprödbrüchen und Kantenbrüchen ist es jedoch angebracht, dass ein erfindungsgemäßer Sinterkörper einen Bindemetallgehalt in Gew.-% von höher 6%, vorzugsweise höher 8%, insbesondere von etwa 10% und höher besitzt.

Im Hinblick auf eine gewünschte Ausbildung des Konditionierbereiches und eine gute Haftvoraussetzung an dessen Oberfläche ist es günstig, wenn das Bindemetall aus Kobalt oder einer Legierung aus Kobalt und/oder Nickel mit Eisen gebildet ist, wobei vorzugsweise der Gehalt an Eisen 5 bis 80 Gew.-%, insbesondere bis 50 Gew.-% beträgt. Das Eisen im Bindemetall hat eine katalytische Funktion für eine Anreicherung von Karbonitrid der Elemente Ti, Nb, Ta an der Oberfläche des Konditionierbereiches und somit zur Schaffung besonders guter Voraussetzungen einer Haftung einer Beschichtung auf diesem. Eisengehalte unter 5 Gew.-% zeigen nicht mehr ein gewünschtes Ergebnis, hingegen wirken mehr als 80 Gew.-% Eisen im Bindemetall zu intensiv auf den Fortschritt einer Karbonitridbildung.

Wenn, wie weiters gemäß der Erfindung vorgesehen sein kann, das Bindemetall aus einer sekundär aushärtbaren Legierung, insbesondere aus einer Legierung mit einer Zusammensetzung ähnlich derjenigen von Schnellstählen gebildet ist, kann eine weitere Härtesteigerung des Hartmetallgegenstandes erzielt werden.

Wie früher erwähnt, ist von besonderem Vorteil, wenn vom inneren Sinterkörper zur Oberfläche hin im Konditionierbereich zumindest gleich hohe Materialhärte vorliegt, vorzugsweise steigende Härte, insbesondere gleichmäßig steigende Härte des Werkstoffes gegeben ist, wobei die Härte als Durchschnittswert mit Vickers-Mikrohärte-Prüfung (HV_{0.1}) ermittelt wird. Derart kann eine aus einer oder mehreren Schichten aufgebaute Beschichtung dünn und elastisch ausgeführt sein und einer Rissinitiation entgegenwirken.

Für eine Stabilität und eine gesicherte Güte der gesamten Oberflächenzone eines erfindungsgemäßen Hartmetallkörpers ist es von Vorteil, wenn der Konditionierbereich eine Dicke von mindestens 3 µm, vorzugsweise von mindestens 5 µm bis 50 µm aufweist. Im Konditionierbereich liegen an der Oberfläche mit Vorteil geringe Gehalte an Wolframkarbid, beispielsweise von 20 bis 35 Gew.-%, 7 und geringe Bindemetallgehalte von 3,5 bis 5,5 Gew.-% vor, sodass bei einer Dicke des Konditionierbereiches von unter 3 µm eine sprunghafte Strukturänderung gegeben ist, welche eine Rissinitiationsgefahr erhöht. Größere Konditionierbereichtiefen als 50 µm sind mit vergrößertem Aufwand herzustellen und bringen keine weiteren Verbesserungen der Haftung der Beschichtung.

Eine Haftfestigkeit der Beschichtung mit einer Flächenverzahnung im Nahometer-Bereich und einer Initiation einer mikrokristallinen Ausbildung der Beschichtung kann erreicht werden, wenn der Konditionierbereich einen Gehalt von 40 bis 80 Gew.-% Karbonitrid von Metallen der Gruppen 4 und 5 des Periodensystems, vorzugsweise einen solchen von 50 bis 70 Gew.-% sowie Wolframkarbid (WC) und Bindemetalle aufweist.

Bei einer besonders vorteilhaften Ausgestaltung der Erfindung ist vorgesehen, dass die nach dem Hochtemperaturverfahren auf den Könditionierbereich des Sinterkörpers aufgebrachte Beschichtung bzw. die Auflageschicht mikrokristallin sowie strukturiert ausgebildet ist und bei mikroskopischer Betrachtung eine rötlich-orange Farbe mit dunkleren Streifen aufweist und im Wesentlichen aus Titan-Karbonitrid (Ti(CₓN_{y})) besteht. Derart kann einerseits eine optimale Haftung der Beschichtung am Konditionierbereich des Hartmetallkörpers erreicht werden, andererseits senkt die Struktur der Auflageschicht bedeutend die Rissinitiation und den Rissfortschritt in dieser.

Der Oberflächenbereich der Kondidonierschicht besitzt einen höheren Gehalt an Mischkarbid, sodass eine Beschichtung aus Titan-Karbonitrid kontinuierlich weitergebildet ist und beste Haftung besitzt.

Wenn, wie mit Vorteil vorgesehen sein kann, die Titan-Karbonitridbeschichtung eine im Wesentlichen aus Aluminiumoxid (Al₂O₃) gebildete Deckschicht trägt, so ist die Schneidleistung des Werkzeuges wesentlich erhöht und der Kolkverschleiß vermindert. Die Al₂O₃-Deckschicht wirkt sowohl als Reaktions- bzw. Oxidationsschutz als auch als Wärmeschutz der schlechten Wärmeleitung der Oxidschicht wegen für die darunterliegende Titan-Karbonitridbeschichtung.

Es kann zur Steigerung der Einsatzdauer eines Werkzeuges auch günstig sein, wenn die Titan-Karbonitridbeschichtung eine im Wesentlichen aus Titan-Aluminium-Nitrid ((TiₓAl_{y})N) gebildete Schicht trägt.

In einer besonderen Form der Erfindung mit optimierten Gebrauchseigenschaften für Wendeschneidplatten im harten Betrieb ist vorteilhaft, wenn der Konditionerbereich am Sinterkörper eine Dicke von 1 bis 35 µm, vorzugsweise von 2 bis 25 µm besitzt, die Ti(CₓN_{y})-Beschichtung bzw. Auflageschicht eine Dicke von 1 bis 22 µm, vorzugsweise von 2 bis 15 µm und wahlweise eine Al₂O₃-Deckschicht mit einer Stärke von 1 bis 25 µm, vorzugsweise 1 bis 15 µm oder eine ((TiₓAl_{y})N-Deckschicht mit einer Stärke von 0,5 bis 12 µm, vorzugsweise von 0,6 bis 0,9 µm aufweist.

Die weitere der Erfindung zugrunde liegende Aufgabe wird bei einem gattungsgemäßen Verfahren dadurch gelöst, dass aus einem Pressling bzw. Grünling mittels Sinterns ein Sinterkörper bzw. Hartmetallkörper mit mehr als 5 Gew.-% Mischkarbiden der Elemente Ti und/oder Nb und/oder Ta mit gewünschten geometrischen Abmessungen gebildet wird, wobei oder worauf durch ein Glühen in einer Stickstoff enthaltenden Atmosphäre oberflächlich ein Konditionierbereich mit einem Kohlenstoffgehalt und einer nach auBßen hin steigenden Stickstoffkonzentration geschaffen wird, auf welchem eine Abscheidung einer feinkörnigen bzw. mikrokristallinen, strukturierten Auflageschicht aus Karbonitrid nach dem CVD-Verfahren unter Verwendung von CH₄ und N₂ bei einer Temperatur von über 900°C erfolgt.

Die Vorteile des erfindungsgemäßen Verfahrens basieren auf der Zusammensetzung des Grünlings und in der Folge des Sinterkörpers. Bei einem langzeitigen Sintern, insbesondere im Vakuum, kann aus reaktionskinetischen Gründen eine Anreicherung von Wolframkarbid und Bindemetall an der Oberfläche des Sinterkörpers entstehen. Wird jedoch ein kurzzeitiges Sintem im Vakuum und in der Folge ein weiteres Sintern oder ein Glühen unter einer Stickstoff enthaltenden und/oder abgebenden Atmosphäre durchgeführt, erfolgt unmittelbar eine Anreicherung von Karbonitriden in einem Bereich unter der Oberfläche und derart eine Ausbildung eines Konditionierbereiches mit bis zu 70% Titan und/oder Niob und/oder Tantal Karbonitride. Dabei ist es erfindungsgemäß wesentlich, dass Kohlenstoff und Stickstoff im Konditionierbereich in ausreichendern Maße enthalten sind oder insbesondere Stickstoff nach außen steigend eingestelllt wird. Diese Konditionierschicht kann durch die Parameter Temperatur und Art der Stickstoff abgebenden Gasatmosphäre in ihrer Dimension und Zusammensetzung ausgebildet und dabei ein verminderter örtlicher, gegebenenfalls 4 Gew.-% aufweisender Bindemetallgehalt und gegebenenfalls eine auf 20 Gew.-% reduzierte Wolframkonzentration erreicht werden, wobei diese Werte keine Untergrenze darstellen müssen. Bei dieser Anreicherung von sogenannten Mischkarbiden an der Außenoberfläche des Konditionierbereiches werden eine im Nanobereich strukturierte Oberfläche und eine günstige Voraussetzung für ein Aufwachsen einer Beschichtung geschaffen. Eine Erstellung der Beschichtung erfolgt nach dem CVD-Verfahren, wobei ein CH₄ und N₂ enthaltendes Gas verwendet wird, um sowohl Kohlenstoff als auch Stickstoff im Prozess bereitzustellen. Für eine gewünschte Initiation einer Reaktion der Beschichtungselemerite ist eine Temperatur im Bereich über 900°C anzuwenden, wobei höhere Beschichtungstemperaturen bis 1050°C Vorteile bringen. Die Steuerung der Reaktion erfolgt derart, dass aus der Oberfläche der Konditionierschicht Kohlenstoff quasi herausgesaugt und beim Dampfniederschlag in die Beschichtungsverbindung eingebracht wird, sodass eine innige Haftung zwischen nanostrukturiertem Substrat und Beschichtung erfolgt.

Erfindungsgemäß ist vorgesehen, dass ein Sinterkörper mit jeweils mehr als 7,5 Gew.-%, vorzugsweise mehr als 8,5 Gew.-%, insbesondere mehr als 10 Gew.-% Mischkarbiden der Elemente der Gruppe 4 und/oder der Gruppe 5 des Periodensystems, vorzugsweise von Ti und/der Nb und/oder Ta erstellt wird, um günstige Voraussetzungen für eine Erstellung einer gewünscht ausgeformten Konditionierschicht zu schaffen.

Bei den Entwicklungsarbeiten hat sich als günstig für die Erzeugnisgüte herausgestellt, wenn ein Sinterkörper mit einem Bindemetallgehalt von höher als 6 Gew.-%, vorzugsweise von höher als 8 Gew.-%, insbesondere von etwa 10 Gew.-% und höher erstellt und als Bindernetall Kobalt und/oder Nickel und/oder Eisen verwendet werden.

In einer besonderen Ausführungsform der Erfindung kann vereinfachend vorgesehen sein, dass pulverförmige, metallische Einzelkomponenten, zum Beispiel Kobalt, Nickel, Eisen und/oder deren Legierungen, den pulverförmigen Karbiden zugesetzt werden und beim Sintern durch Diffusion eine Ausbildung der Zusammensetzung des Bindemetalls erfolgt. Derart sind höchst wirtschaftlich und präzise gewünschte Bindernetallzusammensetzungen erreichbar.

Zur erfindungsgemäßen Ausformung der die Beschichtung tragenden Oberflächenschicht ist es von Wichtigkeit, dass mittels Glühens am Sinterkörper oder Hartmetallkörper bei einem Druck von (1 bis 20) x 10⁶ Pa, vorzugsweise bei einem Druck von (5 bis 10) x 10⁵ Pa, und einer Temperatur von weniger als der Sintertemperatur, jedoch höher als 800°C in stickstoffhältiger Atmosphäre ein Konditionierbereich mit vom Sinterkörper zur Oberfläche hin zumindest gleich hoher Materialhärte, vorzugsweise von steigender Härte, insbesondere von gleichmäßig steigender Härte (Durchschnittswert einer Mikrohärte-(HV_{0.1})-Ermittlung) gebildet und/oder der Bindemetallgehalt auf einen Wert von (0,25 bis 0,8)mal der Bindemetallwert des Sinterkörpers gesenkt wird (werden).

Für eine Anreicherung der Mischkarbide im Konditionierbereich sind der Druck, die Temperaturbeaufschlagung und die Zeit wesentlich. Eine wirtschaftliche Behandlung des Sinterkörpers erfolgt bei einem Druck der stickstoffhältigen Atmosphäre von mindestens 1 x 10⁵ Pa und bei einer Temperatur von höher als 800°C, weil dabei sich erstmalig eine effiziente Reaktion und Diffusion der Verbindungselemente einstellt. Ein höherer Druck als 20 x 10⁵ Pa und/oder eine Glühtemperatur von über 1050°C, insbesondere von über 1120°C, führen zu einer Vergröberung und einer schlechten Kontrollierbarkeit der Ausbildung des Konditionierbereiches.

Wenn, wie gemäß der Erfindung, im Konditionierbereich ein Gehalt an Karbonitrid der Gruppen 4 und 5 des Periodensystems, vorzugsweise ein Gehalt an Titan-und/oder Niob- und/oder Tantal-Karbonitrid (Ti,Nb,Ta)(C,N) von 40 bis 80 Gew.-%, vorzugsweise von 50 bis 70 Gew.-% eingestellt wird, so erfolgt dabei, wie gefunden wurde, eine Ausbildung einer nanostrukturierten Oberfläche, auf welcher in der Folge im Wesentlichen ohne Grenzbereichsspannungen zu erstellen, verzahnt ein Anwachsen von Titan-Karbonitrid erfolgt, das nach dem Hochtemperatur CVD-Verfahren aufgebracht wird.

Beste Zerspanungsergebnisse beim Drehen mit unterbrochenem Schnitt können erreicht werden, wenn ein Konditionierbereich mit einer Dicke von größer 3 µm geschaffen und auf diesen eine mikrokristalline, strukturierte Beschichtung aus im Wesentlichen Titan-Karbonitrid Ti(CₓN_{y}) mit einer Schichtdicke von 1 bis 22 µm nach dem Hochtemperatur-CVD-Verfahren aufgebracht wird, auf welcher ein Abscheiden einer Deckschicht wahlweise aus im Wesentlichen Aluminium oxid (Al₂O₃) mit einer Schichtstärke von 1 bis 25 µm oder aus im Wesentlichen Titan-Aluminium-Nitrid ((TiₓAL_{y})N) mit einer Schichtstärke von 0,5 bis 12 µm, vorzugsweise von 0,6 bis 9,0 µm, erfolgt.

Eine geringere Dicke des Konditionierbereiches als 3 µm kann wegen eines zu hohen Gehaltes an Bindephase und Wolframkarbid zu einer geringen Haftung der Beschichtung führen. Die aus Titan-Karbonitrid gebildete Beschichtung ist nur bei einer Dicke von 1 µm und größer wirksam, wobei ab ca. 6 bis 9 µm die besten Ergebnisse erreicht werden. Dabei ist es erfindungswesentlich, das
Hochtemperatur-CVD-Verfahren einzusetzen, weil die Reaktionskinetik bei
Temperaturen über 900°C in gewünschter Form abläuft. Unter 900°C beim Einsatz von CH₃CN und TiCl₄ als Beschichtungsgas kann sich bei Anwesenheit von Kohlenstoff an der Substratoberfläche gegebenenfalls eine Kohlenstoff-Phase ausbilden, welche weich ist und haftungsverschlechternd wirkt. Weiters wird eine Beschichtung mit einer Korngröße von gegebenenfalls ca. 75 nm gebildet, die zumeist graue Farbe besitzt.

Gemäß der Erfindung erfolgt jedoch die Aufbringung der Beschichtung über 900°C, wobei diese eine rötlich-gelb-orange Farbe besitzt und einen mittleren Korndurchmesser von gegebenenfalls ca. 25 nm hat, also sich deutlich mit Vorteil feinkörniger ausbildet, wobei innere Strukturen, die im Mikroskop etwas dunkler erscheinen, eine Rissinitiation weiter vermindern und eine Verschleißfestigkeit wesentlich verbessern.

Im Folgenden wird die Erfindung anhand von Prinzipskizzen und Ergebnissen näher erläutert.
Es zeigen :
Fig. 1 Hartmetall;
Fig. 2 Hartmetall mit einem Konditionierbereichᵢ
Fig. 3 Hartmetall mit einer HT-CVD-Beschichtungᵢ
Fig. 4 Hartmetall mit einem Konditionierbereich und einer HT-CVD-Beschichtungᵢ
Fig. 5 Ergebnisse von Zerspanungsversuchen.

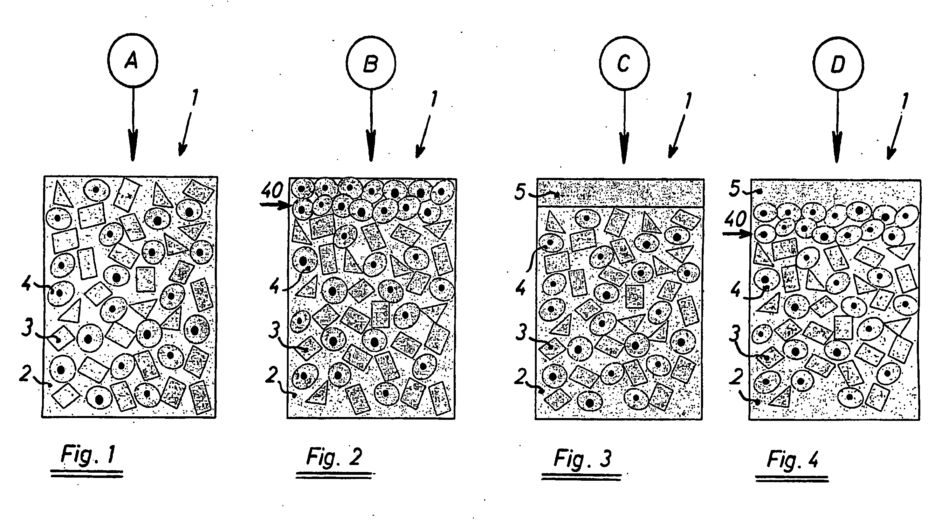

Fig. 1 zeigt schematisch einen Hartmetallgegenstand 1 mit einer Bezeichung A, welcher aus einem Bindemetall 2 und Wolframkarbid-Teilchen 3 und Mischkarbidpartikel 4 in diesem gebildet ist.

In Fig. 2 ist ein Hartmetallgegenstand 1 dargestellt, der gleichartig wie jener in Fig. 1 aufgebaut ist. Allerdings besitzt dieser an einer Oberfläche einen Konditionierbereich 40, welcher höhere Gehalte an Mischkarbiden 4 mit nach außen hin steigenden Stickstoffgehalte aufweist (Bezeichung B).

Fig. 3 stellt einen Hartmetallgegenstand 1 wie in Fig. 1 dar, jedoch trägt dieser eine HT-CVD-Beschichtung 5 und ist mit C bezeichnet.

Aus Fig. 4 ist ein Hartmetallgegenstand 1 (Bezeichung D) entnehmbar, welcher einen Konditionierbereich 40 und eine HT-CVD-Beschichtung 5 aufweist.

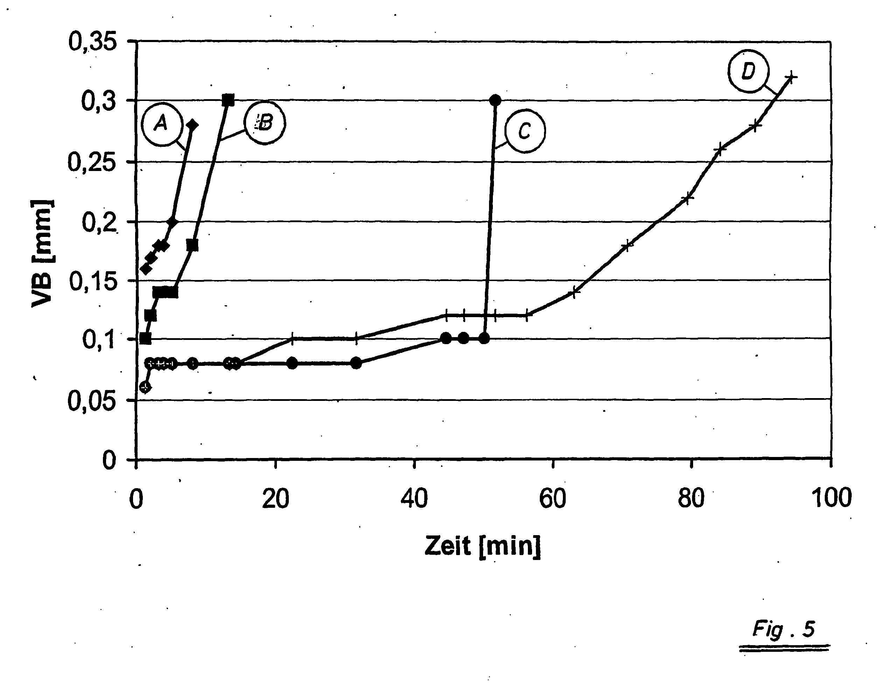

### Aus Fig. 5 sind die Ergebnisse von Zerspanungsversuchen ersichtlich:

Hartmetall-Wendeschneidplatten mit gleicher Zusammensetzung, und zwar:

| | |
|---|---|
| Wolframkarbid (WC) | 60 Gew.-% |
| Mischkarbid (Ti,Nb,Ta)C | 30 Gew.-% |
| Bindemetall (Co) | 10 Gew.-% |

und gleicher Geometrie wurden in vier verschiedenen Arten eine Oberflächenausführung entsprechend der Bezeichung A, B, C, D in Fig. 1 bis 4 hergestellt.

An einem Drehling mit einer Zusammensetzung nach DIN Werkstoffnummer 1.6582 erfolgten bei einer Schnittgeschwindigkeit von 220 m/min, einer Spantiefe von 2 mm und einem Vorschub von 0,28 mm je Umdrehung bei Trockenschnitt jeweils Abspanungen, wobei in Zeitabständen ein Verschleißbereich gemessen wurde.

Aus der Darstellung kann im Vergleich mit Hartmetall A ersehen werden, dass mit einem Konditionierbereich (Kurve B) durch dessen hohe Härte eine Standzeitverbesserung erreicht wird.

Deutlich ist eine die Standzeit verbessernde Wirkung einer Hochtemperatur-CVD-Beschichtung auf Hartmetall (Kurve C) und auf Hartmetall mit einem Konditionierbereich (Kurve D) zu sehen.

Bei einem erfindungsgemäßen Werkzeug (Kurve D) ist weiters festgestellt worden, dass ein Verschleißfortschritt nur langsam steigend ausgebildet ist, weil eine besonders ausgeprägte Haftung der Beschichtung an einem Substrat mit einem hohen Konditionierbereich mit hoher Härte, insbesondere mit hoher Verschleißbeständigkeit, vorliegt.

## Patentansprüche

1. Beschichteter Hartmetallkörper mit erhöhter Verschleißfestigkeit, gebildet durch Sintern von Karbiden und gegebenenfalls Karbonitriden sowie Bindemetall mit einer auf den Sinterkörper aufgebrachten CVD-Beschichtung, wobei der Sinterkörper mehr als 5 Gew.-% Mischkarbide der Elemente Ti und/oder Nb und/oder Ta enthält, oberflächlich einen Konditionierbereich mit einem Kohlenstoffgehalt und einem nach außen hin steigenden Stickstoffgehalt aufweist und eine feinkörnige bzw. mikrokristalline Auflageschicht aus Nitrid und/oder Karbid und/oder Karbonitrid besitzt, die nach dem CVD-Verfahren bei einer Temperatur von über 900°C aufgebracht ist.

2. Hartmetallkörper nach Anspruch 1, **dadurch gekennzeichnet, dass** der Sinterkörper mehr als 7,5 Gew.-%, vorzugsweise mehr als 8,5 Gew.-%, insbesondere mehr als 10 Gew.-% Karbid oder Karbonitrid der Elemente Ti und/oder Nb und/oder Ta enthält.

3. Hartmetallkörper nach Anspruch 1 oder 2, **dadurch gekennzeichnet, dass** der Sinterkörper einen Bindemetallgehaft in Gew.-% von höher 6 %, vorzugsweise von höher 8 %, insbesondere von etwa 10 % und höher besitzt.

4. Hartmetallkörper nach Anspruch 3, **dadurch gekennzeichnet, dass** das Bindemetall aus Kobalt oder einer Legierung aus Kobalt und/oder Nickel mit Eisen gebildet ist, wobei vorzugsweise der Gehalt an Eisen 5 bis 80 Gew.-%, insbesondere bis 50 Gew.-% beträgt.

5. Hartmetallkörper nach Anspruch 3 oder 4, **dadurch gekennzeichnet, dass** das Bindemetall aus einer sekundär aushärtbaren Legierung, insbesondere aus einer Legierung mit einer Zusammensetzung ähnlich derjenigen von Schnellstählen gebildet ist.

6. Hartmetallkörper nach einem der Ansprüche 1 bis 5, **dadurch gekennzeichnet, dass** vom inneren Sinterkörper zur Oberfläche hin im Konditionierbereich zumindest gleich hole Materialhärte vorliegt, vorzugsweise steigende Härte, insbesondere gleichmäßig steigende Härte des Werkstoffes gegeben ist, wobei die Härte als Durchschnittswert mit Vickers-Mikrohärte-Prüfung (HV_{0.1}) ermittelt wird.

7. Hartmetallkörper nach einem der Ansprüche 1 bis 6, **dadurch gekennzeichnet, dass** der Konditionierbereich eine Dicke von mindestens 3 µm, vorzugsweise von 5 bis 50 µm aufweist.

8. Hartmetallkörper nach einem der Ansprüche 1 bis 7, **dadurch gekennzeichnet, dass** der Konditionierbereich einen Gehalt von 40 bis 80 Gew.-% Karbonitrid von Metallen der Gruppen 4 und 5 des Periodensystems, vorzugsweise einen solchen von 50 bis 70 Gew.-% sowie Wolframkarbid (WC) und Bindemetalle aufweist.

9. Hartmetallkörper nach einem der Ansprüche 1 bis 8, **dadurch gekennzeichnet, dass** die nach dem Hochtemperaturverfahren auf den Konditionierbereich des Sinterkörpers aufgebrachte Beschichtung bzw. die Auflageschicht mikrokristallin sowie strukturiert ausgebildet ist und bei mikroskopischer Betrachtung eine rötlich-orange Farbe mit dunkleren Streifen aufweist und im Wesentlichen aus Titan-Karbonitrid (Ti(CₓN_{y})) besteht.

10. Hartmetallkörper nach einem der Ansprüche 1 bis 9, **dadurch gekennzeichnet, dass** die Titan-Karbonitridbeschichtung eine im Wesentlichen aus Aluminiumoxid (Al₂O₃) gebildete Deckschicht trägt.

11. Hartmetallkörper nach einem der Ansprüche 1 bis 9, **dadurch gekennzeichnet, dass** die Titan-Karbonitridbeschichtung eine im Wesentlichen aus Titan-Aluminium-Nitrid ((TiₓAl_{y})N) gebildete Schicht trägt.

12. Hartmetallkörper nach einem der Ansprüche 1 bis 11, **dadurch gekennzeichnet, dass** der Konditionierbereich am Sinterkörper eine Dicke von 1 bis 35 µm, vorzugsweise von 2 bis 25 µm besitzt, die Ti(CₓN_{y})-Beschichtung bzw. Auflageschicht eine Dicke von 1 bis 22 µm, vorzugsweise von 2 bis 15 µm und wahlweise eine Al₂O₃-Deckschicht mit einer Stärke von 1 bis 25 µm, vorzugsweise 1 bis 15 µm oder eine (TiₓAl_{y})N-Deckschicht mit einer Stärke von 0,5 bis 12 µm, vorzugsweise von 0,6 bis 0,9 µm aufweist.

13. Verfahren zur Herstellung von beschichteten Hartmetallkörpem durch Sintern von Karbiden und Bindemetall mit Aufbringen einer CVD-Beschichtung auf den Sinterkörpern, wobei aus einem Pressling bzw. Grünling mittels Sinterns ein Sinterkörper bzw. Hartmetallkörper mit mehr als 5 Gew.-% Mischkarbiden der Elemente Ti und/oder Nb und/oder Ta mit gewünschten geometrischen Abmessungen gebildet wird, wobei oder worauf durch ein Glühen in einer Stickstoff enthaltenden Atmosphäre oberflächlich ein Konditionierbereich mit einem Kohlenstoffgehalt und einer nach außen hin steigenden Stickstoffkonzentration geschaffen wird, auf welcher eine Abscheidung einer feinkörnigen bzw. mikrokristallinen, strukturierten Auflageschicht aus Karbonitrid nach dem CVD-Verfahren unter Verwendung von CH₄ und N₂ bei einer Temperatur von über 900°C erfolgt.

14. Verfahren nach Anspruch 13, **dadurch gekennzeichnet, dass** ein Sinterkörper mit jeweils mehr als 7,5 Gew.-%, vorzugsweise mehr als 8,5 Gew.-%, insbesondere mehr als 10 Gew.-% Mischkarbiden der Elemente der Gruppe 4 und/oder der Gruppe 5 des Periodensystems, vorzugsweise von Ti und/oder Nb und/oder Ta erstellt wird.

15. Verfahren nach Anspruch 13 oder 14, **dadurch gekennzeichnet, dass** ein Sinterkörper mit einem Bindemetallgehalt von höher 6 Gew.-%, vorzugsweise von höher 8 Gew.-%, insbesondere von etwa 10 Gew.-% und höher erstellt wird.

16. Verfahren nach Anspruch 15, **dadurch gekennzeichnet, dass** als Bindemetall Kobalt und/oder Nickel und/oder Eisen verwendet wird.

17. Verfahren nach einem der Ansprüche 13 bis 16, **dadurch gekennzeichnet, dass** pulverförmige, metallische Einzelkomponenten, zum Beispiel Kobalt, Nickel, Eisen und/oder deren Legierungen, den Karbiden zugesetzt werden und beim Sintern durch Diffusion eine Ausbildung der Zusammensetzung des Bindemetalls erfolgt.

18. Verfahren nach einem der Ansprüche 13 bis 17, **dadurch gekennzeichnet, dass** mittels Glühens am Sinterkörper oder Hartmetallkörper bei einem Druck von (1 bis 20) x 10⁵ Pa, vorzugsweise bei einem Druck von (5 bis 10) x 10⁵ Pa und bei einer Temperatur von weniger als der Sintertemperatur, jedoch höher als 800°C in stickstoffhältiger Atmosphäre oberflächlich ein Konditionierbereich mit vom Sinterkörper zur Oberfläche hin zumindest gleichhoher Materialhärte, vorzugsweise von steigender Härte, insbesondere von gleichmäßig steigender Härte (Durchschnittswert einer Mikrohärte-(HV_{0,1})-Ermittlung) gebildet und/oder der Bindemetallgehalt auf einen Wert von (0,25 bis 0,8) mal der Bindemetallgehalt des Sinterkörpers gesenkt wird (werden).

19. Verfahren nach einem der Ansprüche 13 bis 18, **dadurch gekennzeichnet, dass** im Konditionierbereich ein Gehalt an Karbonitrid der Gruppen 4 und 5 des Periodensystems, vorzugsweise ein Gehalt an Titan- und/oder Niob- und/oder Tantal-Karbonitrid (Ti,Nb,Ta)(C,N) von 40 bis 80 Gew.-%, vorzugsweise von 50 bis 70 Gew.-% eingestellt wird.

20. Verfahren nach einem der Ansprüche 13 bis 19, **dadurch gekennzeichnet, dass** ein Konditionierbereich mit einer Dicke von größer 3 µm geschaffen und auf diesen eine mikrokristalline, strukturierte Beschichtung aus im Wesentlichen Titan-Karbonitrid Ti(CₓN_{y}) mit einer Schichtdicke von 1 bis 22 µm nach dem Hochtemperatur-CVD-Vertahren aufgebracht wird, auf welcher ein Abscheiden einer Deckschicht wahlweise aus im Wesentlichen Aluminiumoxid (Al₂O₃) mit einer Schichtstärke von 1 bis 25 µm oder aus im Wesentlichen Titan-Aluminium-Nitrid ((TiₓAl_{y})N) mit einer Schichtstärke von 0,5 bis 12 µm, vorzugsweise von 0,6 bis 9,0 µm, erfolgt.

## Claims

1. Coated hard metal member with increased wear resistance, formed by sintering of carbides and, if applicable, carbonitrides and auxiliary metal with a CVD coating applied onto the sinter member, wherein the sinter member contains more than 5% by weight mixed carbides of the elements Ti and/or Nb and/or Ta, has on the surface a conditioning area with a carbon content and a nitrogen content which increases towards the outside, and has a fine-grained or microcrystalline application layer of nitride and/or carbide and/or carbonitride, which is applied by the CVD process at a temperature of over 900°.

2. Hard metal member according to Claim 1, **characterized in that** the sinter member contains more than 7.5 % by weight, preferably more than 8.5 % by weight, in particular more than 10 % by weight carbide or carbonitride of the elements Ti and/or Nb and/or Ta.

3. Hard metal member according to Claim 1 or 2, **characterized in that** the sinter member has an auxiliary metal content in % by weight of greater than 6 %, preferably of greater than 8 %, in particular of approximately 10 % and above.

4. Hard metal member according to Claim 3, **characterized in that** the auxiliary metal is formed from cobalt or an alloy of cobalt and/or nickel with iron, wherein preferably the iron content is 5 to 80 % by weight, in particular up to 50 % by weight.

5. Hard metal member according to Claim 3 or 4, **characterized in that** the auxiliary metal is formed from a secondarily hardenable alloy, in particular of an alloy with a composition similar to that of high-speed steels.

6. Hard metal member according to any of Claims 1 to 5, **characterized in that** from the inner sinter member towards the surface in the conditioning area at least an equally high material hardness is present, preferably an increasing hardness, in particular a uniformly increasing hardness of the material exists, the hardness being determined as an average value by Vickers microhardness testing (HV_{0,1}).

7. Hard metal member according to any of Claims 1 to 6, **characterized in that** the conditioning area has a thickness of at least 3 µm, preferably of 5 to 50 µm.

8. Hard metal member according to any of Claims 1 to 7, **characterized in that** the conditioning area has a content of 40 to 80 % by weight carbonitride of metals of the groups 4 and 5 of the periodic system, preferably a content of 50 to 70 %, and tungsten carbide (WC) and auxiliary metals.

9. Hard metal member according to any of Claims 1 to 8, **characterized in that** the coating or the application layer which is applied onto the conditioning area of the sinter member by the high temperature method is microcrystalline and is formed in a structured manner and on microscopic observation has a reddish-orange colour with darker stripes and consists substantially of titanium carbonitride (Ti (CₓN_{y}) ) .

10. Hard metal member according to any of Claims 1 to 9, **characterized in that** the titanium carbonitride coating carries a covering layer formed substantially of aluminium oxide (Al₂O₃) .

11. Hard metal member according to any of Claims 1 to 9, **characterized in that** the titanium carbonitride coating carries a layer formed substantially of titanium aluminium nitride ((TixAly) N) .

12. Hard metal member according to any of Claims 1 to 11, **characterized in that** the conditioning area on the sinter member has a thickness of 1 to 35 µm, preferably of 2 to 25 µm, the Ti(CₓN_{y}) coating or application layer has a thickness of 1 to 22 µm, preferably of 2 to 15 µm and optionally an Al₂O₃ covering layer with a thickness of 1 to 25 µm, preferably 1 to 15 µm or a (TiₓAl_{y})N covering layer with a thickness of 0.5 to 12 µm, preferably of 0.6 to 0.9 µm.

13. Method for the production of coated hard metal members by sintering of carbides and auxiliary metal with the application of a CVD coating on the sinter members, wherein from a compact or from a green perform a sinter member or hard metal member is formed by means of sintering, with more than 5 % by weight mixed carbides of the elements Ti and/or Nb and/or Ta with desired geometric dimensions, wherein or whereupon a conditioning area with a carbon content and an outwardly increasing nitrogen concentration is provided on the surface by an annealing in an atmosphere containing nitrogen, on which a deposition of a fine-grained or microcrystalline, structured application layer of carbonitride takes place by the CVD process, using CH₄ and N₂ at a temperature of over 900°C.

14. Method according to Claim 13, **characterized in that** a sinter member with respectively more than 7.5 % by weight, preferably more than 8.5 % by weight, in particular more than 10 % by weight mixed carbides of the elements of group 4 and/or of group 5 of the periodic system, preferably of Ti and/or Nb and/or Ta is provided.

15. Method according to Claim 13 or 14, **characterized in that** a sinter member with an auxiliary metal content of greater than 6 % by weight, preferably of greater than 8 % by weight, in particular of approximately 10 % by weight and higher is provided.

16. Method according to Claim 15, **characterized in that** cobalt and/or nickel and/or iron is used as auxiliary metal.

17. Method according to any of Claims 13 to 16, **characterized in that** pulverulent, metallic individual components, for example cobalt, nickel, iron and/or their alloys are added to the carbides and on sintering through diffusion a formation of the composition of the auxiliary metal takes place.

18. Method according to any of Claims 13 to 17, **characterized in that** by means of annealing on the sinter member or hard metal member at a pressure of (1 to 20) x 10⁵ Pa, preferably at a pressure of (5 to 10) x 10⁵ Pa and at a temperature of less than the sinter temperature, but higher than 800°C in an atmosphere containing nitrogen, a conditioning area is formed on the surface with a material hardness which is at least equally high from the sinter member towards the surface, preferably of increasing hardness, in particular of uniformly increasing hardness (average value of a microhardness (HV_{0,1}) determination) and/or the auxiliary metal content is reduced to a value of (0.25 to 0.8) times the auxiliary metal content of the sinter member.

19. Method according to any of Claims 13 to 18, **characterized in that** in the conditioning area a content of carbonitride of the groups 4 and 5 of the periodic system, preferably a content of titanium- and/or niobium- and/or tantalum carbonitride (Ti, Nb, Ta)(C, N) of 40 to 80 % by weight, preferably of 50 to 70 % by weight is set.

20. Method according to any of Claims 13 to 19, **characterized in that** a conditioning area with a thickness of greater than 3 µm is created and onto the latter a microcrystalline, structured coating is applied of substantially titanium carbonitride (Ti(CₓN_{y})) with a layer thickness of 1 to 22 µm by the high temperature CVD process, on which a deposition of a covering layer optionally of substantially aluminium oxide (Al₂O₃) takes place with a layer thickness of 1 to 25 µm or of substantially titanium aluminium nitride ((TiₓAl_{y})N) with a layer thickness of 0.5 to 12 µm, preferably of 0.6 to 9.0 µm.

## Revendications

1. Corps en métal dur pourvu d'un revêtement avec une résistance à l'usure élevée, formé par frittage de carbures et le cas échéant de nitrures de carbone ainsi que des métaux auxiliaires avec un revêtement par dépôt chimique en phase vapeur appliqué sur le corps de frittage, dans lequel le corps de frittage contient plus de 5% en poids de carbures mixtes des éléments Ti et/ou Nb et/ou Ta, présente sur sa surface une zone de conditionnement avec une teneur en carbone et une teneur en azote augmentant vers l'intérieur et possède une couche de revêtement à grains fins, respectivement microcristalline en nitrure et/ou carbure et/ou nitrure de carbone, qui est appliquée après le procédé de dépôt chimique en phase vapeur à une température supérieure à 900°C.

2. Corps en métal dur selon la revendication 1, **caractérisé en ce que** le corps de frittage contient plus de 7,5% en poids, de préférence plus de 8,5% en poids, notamment plus de 10% en poids de carbure ou nitrure de carbone des éléments Ti et/ou Nb et/ou Ta.

3. Corps en métal dur selon la revendication 1 ou 2, **caractérisé en ce que** le corps de frittage possède une teneur en métal auxiliaire supérieure à 6% en poids, de préférence supérieure à 8% en poids, notamment d'environ 10% et supérieur.

4. Corps en métal dur selon la revendication 3, **caractérisé en ce que** le métal auxiliaire est formé en cobalt ou un alliage de cobalt et/ou nickel avec du fer, dans lequel de préférence la teneur en fer est compris entre 5 et 80% en poids, notamment s'élève à 50% en poids.

5. Corps en métal dur selon la revendication 3 ou 4, **caractérisé en ce que** le métal auxiliaire est formé par un alliage durcissable secondaire, notamment un alliage avec une composition similaire à celle des aciers rapides.

6. Corps en métal dur selon une des revendications 1 à 5, **caractérisé en ce que** de l'intérieur du corps de frittage jusqu'à la surface en passant par la zone de conditionnement, une dureté de matériau au moins identique est présente, de préférence une dureté croissante, notamment une dureté croissant régulièrement du matériau est donnée, dans lequel la dureté est déterminée comme une valeur moyenne avec un test de microdureté Vickers (HV 0,1).

7. Corps en métal dur selon une des revendications 1 à 6, **caractérisé en ce que** la zone de conditionnement présente une épaisseur d'au moins 3 µm, de préférence comprise entre 5 et 50 µm.

8. Corps en métal dur selon une des revendications 1 à 7, **caractérisé en ce que** la zone de conditionnement présente une teneur en nitrure de carbone de métaux des groupes 4 et 5 du tableau périodique des éléments de 40 à 80% en poids, de préférence une telle teneur de 50 à 70% en poids ainsi que du carbure de wolfram (WC) et des métaux auxiliaires.

9. Corps en métal dur selon une des revendications 1 à 8, **caractérisé en ce que** le revêtement appliqué après le procédé à haute température sur la zone de conditionnement du corps de frittage, respectivement la couche de revêtement a une configuration microcristalline et structurée et présente lors d'une observation au microscope une couleur rouge orangée avec des bandes plus sombres et est essentiellement constituée de nitrure de carbone-titane (Ti (CₓN_{y}) ) .

10. Corps en métal dur selon une des revendications 1 à 9, **caractérisé en ce que** le revêtement de nitrure de carbone-titane supporte une couche de recouvrement formée essentiellement en oxyde d'aluminium (Al₂O₃) .

11. Corps en métal dur selon une des revendications 1 à 9, **caractérisé en ce que** le revêtement de nitrure de carbone-titane supporte une couche formée essentiellement en nitrure d'aluminium-titane ((TiₓAl_{y})N) .

12. Corps en métal dur selon une des revendications 1 à 11, **caractérisé en ce que** la zone de conditionnement sur le corps de frittage possède une épaisseur de 1 à 35 µm, de préférence de 2 à 25 µm, le revêtement Ti(CₓN_{y}), respectivement la couche de revêtement présente une épaisseur de 1 à 22 µm, de préférence de 2 à 15 µm et présente au choix une couche de recouvrement Al₂O₃ avec une épaisseur de 1 à 25 µm, de préférence 1 à 15 µm ou une couche de recouvrement (TiₓAl_{y})N avec une épaisseur de 0,5 à 12 µm, de préférence comprise entre 0,6 et 0,9 µm.

13. Procédé de fabrication de corps en métaux durs pourvus de revêtements par frittage de carbures et de métaux auxiliaires avec application d'un revêtement par dépôt chimique en phase vapeur sur le corps de frittage, dans lequel à partir d'une ébauche pressée, respectivement d'un compact vert un corps de frittage, respectivement un corps en métal dur avec plus de 5% en poids de carbures mixtes des éléments Ti et/ou Nb et/ou Ta est formé avec des dimensions géométriques souhaitées au moyen d'un frittage, dans lequel ou sur lequel par un recuit dans une atmosphère contenant de l'azote une zone de conditionnement avec une teneur en carbone et une concentration d'azote augmentant vers l'intérieur est réalisée en surface, sur laquelle un dépôt d'une couche de recouvrement en nitrure de carbone structurée à grains fins, respectivement microcristalline a lieu selon le procédé de dépôt chimique en phase vapeur en utilisant du CH₄ et du N₂ à une température supérieure à 900°C.

14. Procédé selon la revendication 13, **caractérisé en ce que** un corps de frittage avec respectivement plus de 7,5% en poids, de préférence plus de 8,5% en poids, notamment plus de 10% en poids de carbures mixtes des éléments du groupe 4 et/ou du groupe 5 du tableau périodique des éléments, de préférence de Ti et/ou Nb et/ou Ta est établi.

15. Procédé selon la revendication 13 ou 14, **caractérisé en ce que** un corps de frittage avec une teneur en métal auxiliaire supérieure à 6% en poids, de préférence supérieure à 8% en poids, notamment d'environ 10% en poids et supérieur est réalisé.

16. Procédé selon la revendication 15, **caractérisé en ce que** comme métal auxiliaire du cobalt et/ou du nickel et/ou du fer est utilisé.

17. Procédé selon une des revendications 13 à 16, **caractérisé en ce que** des composants individuels métalliques poudreux, par exemple du cobalt, du nickel, du fer et/ou leurs alliages sont ajoutés aux carbures et une configuration de la composition du métal auxiliaire a lieu lors du frittage par diffusion.

18. Procédé selon une des revendications 13 à 17, **caractérisé en ce que** au moyen d'un recuit sur le corps de frittage ou le corps en métal dur à une pression de (1 à 20) x 10⁵ Pa, de préférence à une pression (5 à 10)x 10⁵ Pa et à une température inférieure à la température de frittage, néanmoins supérieure à 800°C dans une atmosphère contenant de l'azote, une zone de conditionnement avec une dureté de matériau au moins identique en allant du corps de frittage vers la surface est réalisée, de préférence de dureté croissante, notamment d'une dureté croissante uniformément (valeur moyenne d'une détermination de microdureté HV_{0,1}) est formée en surface et/ou la (les) teneur(s) en métal auxiliaire est/sont abaissées à une valeur de (0,25 à 0,8) fois la teneur en métal auxiliaire du corps de frittage.

19. Procédé selon une des revendications 13 à 18, **caractérisé en ce que** dans la zone de conditionnement une teneur en nitrure de carbone des groupes 4 et 5 du tableau périodique des éléments, de préférence une teneur en titane et/ou niobium et/ou nitrure de carbone -tantale (Ti,Nb,Ta)(C,N) de 40 à 80% en poids, de préférence de 50 à 70% en poids est établie.

20. Procédé selon une des revendications 13 à 19, **caractérisé en ce que** une zone de conditionnement avec une épaisseur supérieure à 3 µm est réalisée et, sur celle-ci, un revêtement structuré microcristallin essentiellement en nitrure de carbone-titane Ti(CₓN_{y}) avec une épaisseur de couche de 1 à 22 µm est appliqué selon le procédé de dépôt chimique en phase vapeur à haute température, sur lequel un dépôt d'une couche de recouvrement au choix essentiellement en oxyde d'aluminium (Al₂O₃) avec une épaisseur de couche de 1 à 25 µm ou essentiellement en nitrure d'aluminium-titane ((TiₓAl_{y})N) avec une épaisseur de couche de 0,5 à 12 µm, de préférence de 0,6 à 9,0 µm a lieu.
